# EUROPEAN PATENT SPECIFICATION

(11) **EP 4 425 718 B1**
(45) Date of publication and mention of the grant of the patent: **26.11.2025**
(21) Application number: 23205774.5
(22) Date of filing: 25.10.2023
(51) Int. Cl.: H01R 12/72, H01R 31/00, H05K 1/02, H05K 1/18, H01R 4/34, H01R 12/70, H01R 13/621, H01R 13/629, H01R 27/02, H05K 3/34, H05K 5/00

(54) **CONNECTOR**
VERBINDER
CONNECTEUR

(30) Priority: 03.03.2023 US 202363449909 P; 08.09.2023 CN 202311157817
(43) Date of publication of application: 04.09.2024
(73) Proprietor: Delta Electronics, Inc., Taoyuan City 33370 (TW)
(72) Inventor: Yang, Shan-Chun, 32063 Taoyuan City (TW); Chen, Chien-Chun, 32063 Taoyuan City (TW); Byrne, Vincent Mark, 32063 Taoyuan City (TW)
(74) Representative: Uexküll & Stolberg

(56) References cited:
- US-B2- 6 848 950
- US-B2- 8 696 390

## Description

### FIELD OF THE INVENTION

The present disclosure relates to an electronic assembly structure, and more particularly to a connector combining high-current power supply and signal transmission to reduce the material costs, optimize the assembling process, and improve the space utilization.

### BACKGROUND OF THE INVENTION

In a conventional communication power module, the circuit board is used to carry a large current, and it is necessary to dispose a large area of copper bars on the circuit board to help the heat dissipation. However, if the module capacity is to be improved and a higher current is used in the future, the feasibility of large-area copper for heat dissipation will be limited. In addition, when the power module needs to increase the depth of the system, as the system output current is increased, more space is required for soldering the copper bars and more layers of circuit board are required. Due to the high complexity of the multi-layer circuit board manufacturing process and the system wire and copper busbar fastening process, the overall manufacturing man-hour will be increased. Moreover, the additional materials (such as the copper bars, the circuit boards, the screws, the insulation sheets, etc.) will also increase the cost of materials.

On the other hand, in the conventional communication power module, the signal pins and the power outputs are located at the rear side of the connector, it results in a limited number of power output groups. Furthermore, the space utilization cannot be improved, and the assembling operation are interfered. It needs to be overcome by adjusting the assembling process. An additional wire is required to be assembled on the sheet metal for grounding, and the extra cost of materials is increased.

US 6,848,950 B2 provides an electrical connector, including an insulative housing and one or more power contacts disposed in the insulative housing. Each of the power contacts has a first electrical interface portion for engaging a contact associated with a mating electrical connector, a second electrical interface portion for engaging a printed circuit board, and a third electrical interface portion for engaging a cable plug connector.

US 8,696,390 B2 relates to an electrical connector which includes an insulative housing defining a passageway, a contact received in the passageway and a transfer contact with one end connected to a cable and the other end connected to the contact. The contact includes a retaining portion fixed in the passageway, a contact portion extending forwardly from the retaining portion and a tail portion extending backwardly from the retaining portion. The transfer contact includes a U-shaped portion for receiving the tail portion and a cable connection portion extending from the U-shaped portion for receiving the cable. The U-shaped portion includes a pair of side walls. At least one of the side walls includes an elastic arm engaging with the tail portion of the contact for improving fixation force therebetween.

Therefore, there is a need of providing a connector combining high-current power supply and signal transmission to reduce the material costs, optimize the assembling process, improve the space utilization, and obviate the drawbacks encountered by the prior arts.

### SUMMARY OF THE INVENTION

An object of the present invention is to provide a connector combining high-current power supply and signal transmission to reduce the material costs, optimize the assembling process, and improve the space utilization.

Another object of the present disclosure is to provide a hybrid power connector suitable for connecting to a communication power module. The power inputs and the power outputs are disposed on the opposite input side and output side of the main body, respectively. Each power output includes for example a copper sheet with a screw-fixing hole, and the wire and the copper bar are fixed to the power output, so as to reduce the cost of materials and optimize the assembling procedures. When the signal inputs and the power inputs are introduced from the front input side, the power inputs are electrically connected to the rear power outputs and led out through the output side, and the signal inputs are electrically connected to the signal outputs on the bottom of the main body and then led out through the inner trace of the circuit board below, so as to increase the space utilization. The signal outputs include a plurality of signal output pins, which are fixed to the circuit board through the soldering process, so that the signal can be led out through the trace of the circuit board to the terminal on the circuit board, such as the signal connection socket on the extension portion, to optimize the assembling process. On the other hand, a plurality of power output pins, disposed on the bottom of the main body and electrically connect to the ground input on the input side, are fixed to the circuit board through the soldering process. In that, the grounding is guided to a specific area through the trace of the circuit board, and the circuit board is overlapped with the other metal parts to achieve the purpose of grounding. It allows to arrange a ground conductor in conjunction with the fastening holes of the main body and the circuit board to simultaneously realize the ground connection when the connector is fixed to the housing, and the assembling process is further optimized. Since the power inputs, the signal inputs and the ground input are all arranged on the input side, guide grooves can be set on the input side to guide the docking pin of the communication power module for insertion along the direction from the input side to the output side, so as to complete the docking of the communication power module and the connector easily, and optimize the assembling process.

In accordance with the present invention, a connector is provided. The connector includes a main body, a circuit board and at least one signal connection socket. The main body includes an input side, an output side, a plurality of power inputs, a plurality of signal inputs, a plurality of power outputs and a plurality of signal outputs. The input side is opposite to the output side in a first direction, the plurality of power inputs and the plurality of signal inputs are arranged along a second direction on the input side, the first direction is perpendicular to the second direction, the plurality of power outputs are arranged along the second direction on the output side, the plurality of power outputs are electrically connected to the plurality of power inputs, the plurality of signal outputs are disposed on a bottom side of the main body and electrically connected to the plurality of signal inputs, and the bottom side is connected between the input side and the output side. The circuit board includes an upper surface. The bottom side of the main body is attached to the upper surface. The at least one signal connection socket is disposed on the upper surface and electrically connected to the plurality of signal outputs through the circuit board.

### BRIEF DESCRIPTION OF THE DRAWINGS

The above contents of the present disclosure will become more readily apparent to those ordinarily skilled in the art after reviewing the following detailed description and accompanying drawings, in which:
FIG. 1 is a schematic structural view illustrating a connector according to an embodiment of the present disclosure from a front view;
FIG. 2 is a schematic structural view illustrating the connector according to the embodiment of the present disclosure from a rear perspective;
FIG. 3 is an exploded view illustrating the connector according to the embodiment of the present disclosure from a lower perspective;
FIG. 4 is an exploded view illustrating the connector according to the embodiment of the present disclosure from an upper perspective; and
FIG. 5 and FIG. 6 are continuous schematic diagrams showing the docking relationship between the connector and a communication power module according to the embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

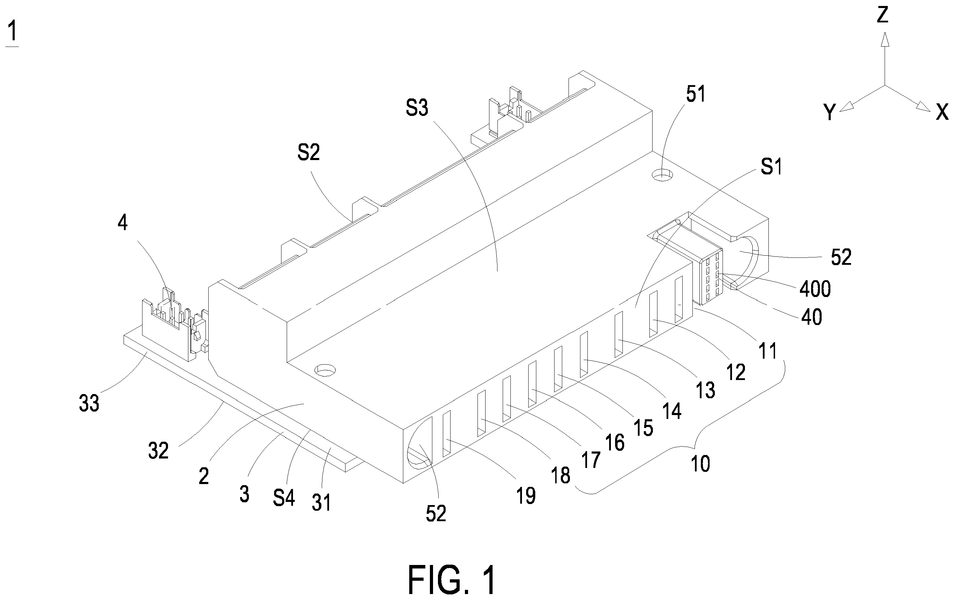

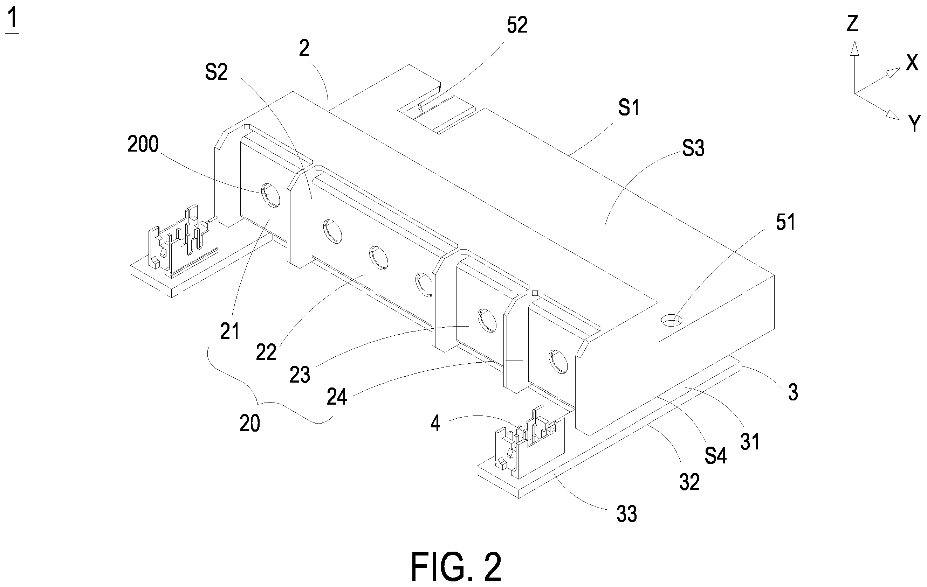

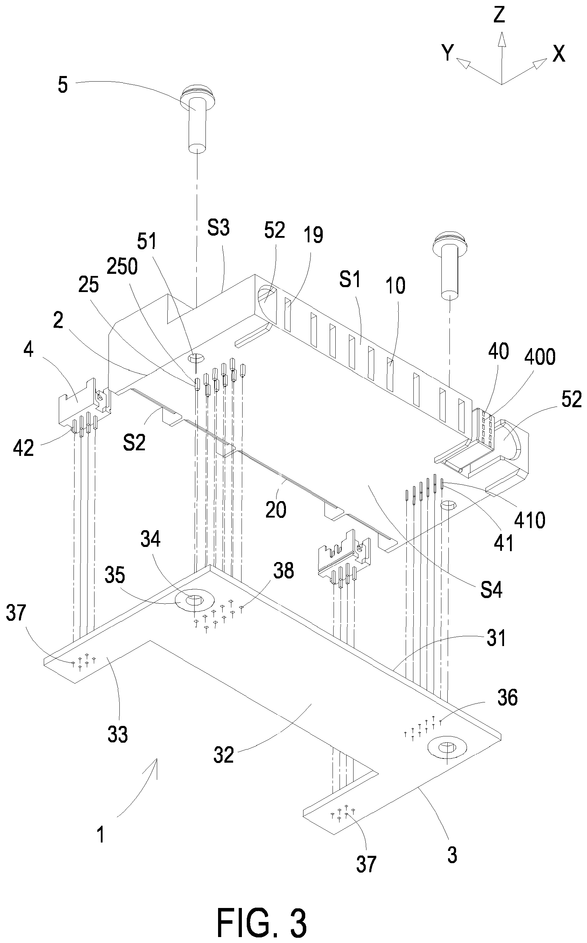

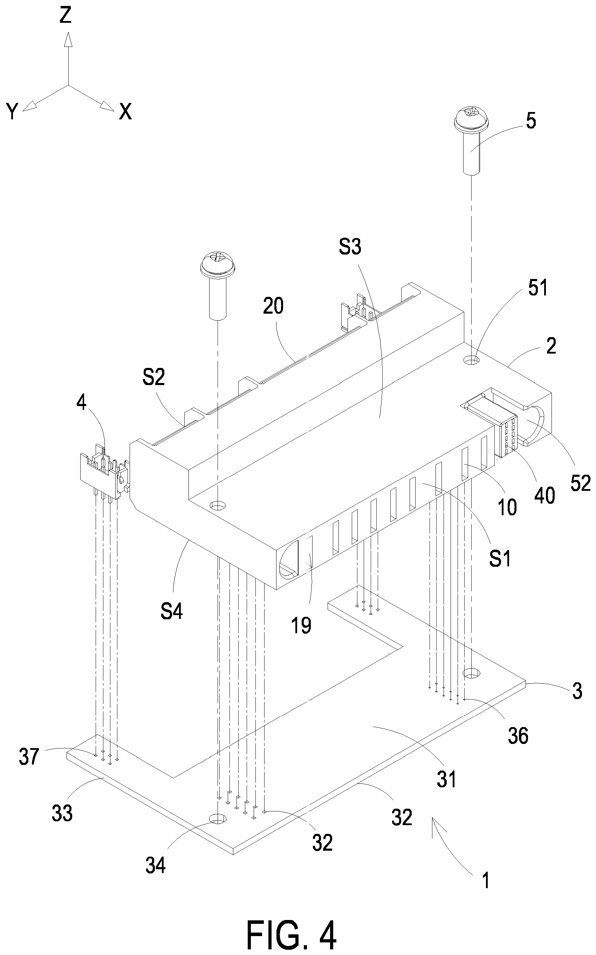

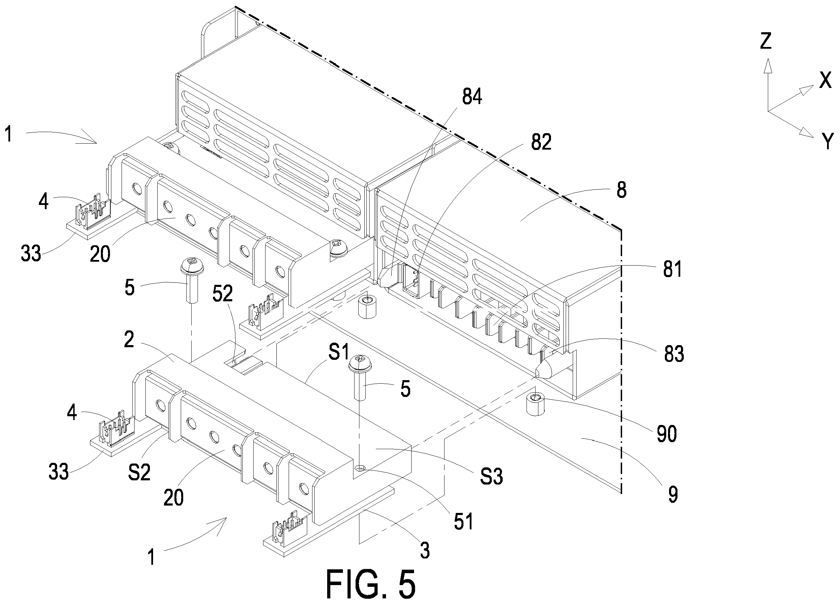

Please refer to FIG. 1 to FIG. 6, which illustrates a connector according to an embodiment of the present disclosure. The present disclosure provides a hybrid power connector 1 suitable for connecting to a communication power module 8, and configured to transmit high-current power and signals of the communication power module 8. The connector 1 includes a main body 2, a circuit board 3 and at least one signal connection socket 4. In the embodiment, the main body 2 includes an input side S1 and an output side S2 opposite to each other, a plurality of power inputs 10, a plurality of signal inputs 40, a plurality of power outputs 20 and a plurality of signal outputs 41. In the X axial direction (a first direction), the front input side S1 is corresponding to the rear output side S2 in position. The plurality of power inputs 10 and the plurality of signal inputs 40 are arranged along the Y axial direction (a second direction) and disposed on the front input side S1. The plurality of power outputs 20 are arranged along the Y axial direction (i.e., the second direction) and disposed on the rear output side S1. Preferably but not exclusively, the first direction is perpendicular to the second direction. The plurality of power outputs 20 are electrically connected to the plurality of power inputs 10, the plurality of signal outputs 41 are disposed on a bottom side S4 of the main body 2 and electrically connected to the plurality of signal inputs 40. The bottom side S4 is connected between the input side S1 and the output side S2. The circuit board 3 includes an upper surface 31 and a lower surface 32. The bottom side S4 of the main body 2 is attached to the upper surface 31 of the circuit board 3. The at least one signal connection socket 4 is disposed on the upper surface 31 of the circuit board 3, and electrically connected to the plurality of signal outputs 41 through the circuit board 3.

Notably, the electrical connection of the plurality of power inputs 10 and the plurality of power outputs 20 is not limited to one-to-one. In the embodiment, the plurality of power inputs 10 includes a plurality of first fixing-terminal apertures marked with numbers 11, 12, 13, 14, 15, 16, 17, and 18 respectively, and arranged on the input side along the second direction (i.e., the Y axial direction), as shown in FIG. 1. In addition, the plurality of signal inputs 40 includes a plurality of second fixing-terminal apertures 400 disposed on the input side S1 and arranged at a lateral side (for example the right side) of the input side S1. Preferably but not exclusively, the plurality of second fixing-terminal apertures 400 are arranged in two rows vertically along the third direction (i.e., the Z axial direction). The third direction is perpendicular to the first direction and the second direction. In other embodiments, the numbers, the arrangements and the types of the first fixing-terminal apertures 11, 12, 13, 14, 15, 16, 17, 18 and the plurality of second fixing-terminal apertures 400 are adjustable according to the practical requirements, and the present disclosure is not limited thereto. In the embodiment, the plurality of power outputs 20 are formed by a plurality of copper sheets 21, 22, 23, 24, which are arranged along the second direction (i.e., the Y axial direction), and spaced apart from each other. Preferably but not exclusively, the plurality of copper sheets 21, 22, 23, 24 are isolated from each other. A plurality of partition plates are extended from the main body 2 toward the output side S2 along the first direction (i.e., the X axial direction), so as to electrically isolate each of the copper sheets 21, 22, 23, 24. Preferably but not exclusively, each of the copper sheets 21, 22, 23, 24 of the power outputs 20 includes at least one screw-fixing hole 200, respectively, configured to fix a wire or a copper bar to a corresponding one of the plurality of copper sheets 21, 22, 23, 24 of the power outputs 20 for an electrical connection. Certainly, the present disclosure is not limited thereto. Preferably but not exclusively, in the embodiment, the first fixing-terminal apertures 11, 12 of the power inputs 10 are connected to the copper sheet 21 of the power outputs 20, the first fixing-terminal apertures 13, 14, 15, 16 of the power inputs 10 are connected to the copper sheet 22 of the power outputs 20, the first fixing-terminal aperture 17 of the power inputs 10 is connected to the copper sheet 23 of the power outputs 20, and the first fixing-terminal aperture 18 of the power inputs 10 is connected to the copper sheet 24 of the power outputs 20. When the plurality of first fixing-terminal apertures of the power inputs 10 on the front input side S1 pass through the main body 2 and are directly led to the copper sheets 21, 22, 23, 24 of the power outputs 20 on the rear output side S2, since the power outputs 20 are formed by the copper sheets 21, 22, 23, 24 with the screw-fixing holes 200, it allows to fix a wire or a copper bar to a corresponding one of the plurality of the copper sheets 21, 22, 23, 24 of the power outputs 20 for high-current transmission, so as to reduce the cost of materials and optimize the assembling procedures. In other embodiments, the relationships (positions and numbers) of the first fixing-terminal apertures 11, 12, 13, 14, 15, 16, 17, 18 of the power inputs 10 correspondingly connected to the copper sheets 21, 22, 23, 24 of the power outputs 20 are adjustable according to the practical requirements. The present disclosure is not limited thereto and not redundantly described hereafter.

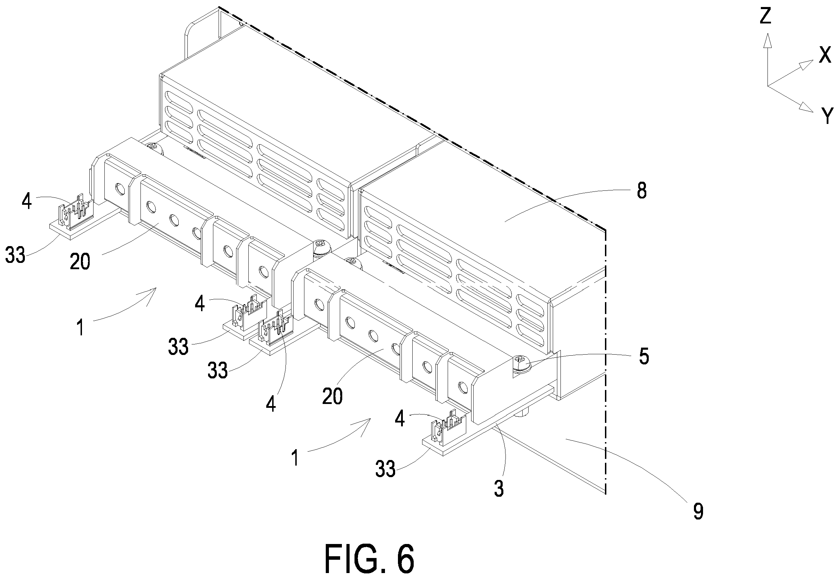

In the embodiment, when the plurality of signal inputs 40 are introduced into the main body 2 through the front input side S1, the configuration of the signal inputs 40 is different from the power inputs 10 electrically connected to the rear power outputs 20 and led out through the output side S2. That is, the plurality of signal inputs 40 are electrically connected to the signal outputs 41 on the bottom side S4 of the main body 2, and then led out through the inner trace of the below circuit board 3, so as to increase the space utilization by the output side S2 of the connector 1. In the embodiment, the circuit board 3 further includes at least one extension portion 33 extended from a side of the circuit board 3 along the X axial direction (i.e., the first direction) and disposed adjacent to the left end or the right end of the output side S2. Moreover, the at least one signal connection socket 4 is disposed on the at least one extension portion 33. After being assembled, the signal connection socket 4 is located at the rear of the output side S3 and adjacent to the left end or the right end of the output side S2. In an embodiment, the circuit board 3 includes two of the extension portions 33 corresponding to two of the signal connection sockets 4. The two extension portions 33 are extended from two opposite ends (i.e., the left end and the right end) on a side of the circuit board 3 and arranged adjacent to the output side S2, respectively, and the two signal connection sockets 4 are disposed on the two extension portions 33 and located on the upper surface 31 of the circuit board 3. When two connectors 1 are arranged along the second direction (i.e., the Y axial direction) for application, as shown in FIG. 6, the right signal connection socket 4 of the left connector 1 and the left signal connection socket 4 of the right connector 1 are arranged adjacent to each other. It is beneficial to realize signal connection with a shorter path, reduce the cost of materials, and avoid the interference of signal transmission. Certainly, the present disclosure is not limited thereto.

In the embodiment, the plurality of signal outputs 41 includes a plurality of signal output pins 410 passing through the bottom side S4 of the main body 2 and connected to the upper surface 31 of the circuit board 3 so as to electrically connect to the circuit board 3. Preferably but not exclusively, in the embodiment, the circuit board 3 includes a plurality of first installation holes 36 passing through the upper surface 31 and the lower surface 32 of the circuit board 3 and spatially corresponding to the plurality of signal output pins 410 of the signal outputs 41. Preferably but not exclusively, the plurality of signal output pins 410 of the signal outputs 41 are fixed to the circuit board 3 through the soldering process, so that the signal can be let out through the trace of the circuit board 3 to the terminal on the circuit board 3, such as the signal connection socket 4 on the extension portion 33, to optimize the assembling process. In the embodiment, the signal connection socket 4 includes a plurality of signal connection pins 42 connected to the upper surface 31 of the circuit board 3. Preferably but not exclusively, the circuit board 3 includes a plurality of second installation holes 37 passing through the upper surface 31 and the lower surface 32 of the circuit board 3 and spatially corresponding to the plurality of signal connection pins 42 of the signal connection socket 4. Preferably but not exclusively, the plurality of signal connection pins 42 of the signal connection socket 4 are fixed to the circuit board 3 through the soldering process. Thereby, the signal can be introduced through the signal inputs 40 on the input side S1, transmitted to the circuit board 3 through the signal outputs 41 on the bottom side S4 of the main body, and then let out through the trace of the circuit board 3 to the signal connection socket 4. The signal transmission path is different from the power transmission path. Notably, the at least one signal connection socket 4 on the extension portion 33 of the circuit board 3 is misaligned to the plurality of power outputs 20 of the main body 2 in a viewing direction from the rear output side S2 to the front input side S1 (i.e., the X axial direction), so as to avoid interfering with each other's installation process.

In the embodiment, the main body 2 further includes a ground input 19 and a ground output 25 electrically connected to each other, the ground input 19 is disposed on the input side S1, and the ground output 25 is disposed on the bottom side S4. Preferably but not exclusively, the ground input 19 is formed in a similar type of the power inputs 10 with the fixing-terminal apertures, and arranged adjacent to a lateral side of the plurality of power inputs 10 along the second direction (i.e., the Y axial direction). Preferably but not exclusively, the ground output 25 includes a plurality of ground output pins 250 passing through the bottom side S4 of the main body 2 and the circuit board 3, so as to be fastened to a housing 9. In an embodiment, the housing 9 includes a communication power module or the other devices. In the embodiment, the circuit board 3 includes a plurality of third installation holes 38 passing through the upper surface 31 and the lower surface 32 of the circuit board 3 and spatially corresponding to the plurality of ground output pins 250 of the ground output 25. In that, the plurality of ground output pins 250 of the ground output 25 are fixed to the circuit board 3 through the soldering process, and pass through the lower surface 32. Thereby, when the connector 1 is fixed to the housing 9, the ground input 19 and the ground output 25 are connected to the housing 9 to realize the grounding. In other embodiments, when the ground output pins 250 of the ground output 25 are fixed to the circuit board 3 through the soldering process, the grounding is guided to a specific area by the trace of the circuit board 3, and then the circuit board 3 is overlapped with the other metal parts to achieve the purpose of grounding. Certainly, the present disclosure is not limited thereto.

In the embodiment, the main body 2 includes at least one first fastening hole 51 passing through the top side S3 and the bottom side S4 of the main body 2. The top side S3 and the bottom side S4 are opposite to each other and located between the input side S1 and the output side S2. The circuit board 3 includes at least one second fastening hole 34, and the at least one first fastening hole 51 is spatially corresponding to the at least one second fastening hole 34, whereby the connector 1 is fixed to the housing 9 along the third directional (i.e., the Z axial direction). Preferably but not exclusively, in the embodiment, a fastening element 5, such as a screw, is utilized to pass through the first fastening hole 51 and the second fastening hole 34 and engage with the engaged element 90 of the housing 9, so that the connector 1 is fixed to the housing 9. In the embodiment, the circuit board 3 includes a ground conductor 35 disposed on the lower surface 32 of the circuit board 3 and electrically connected to the ground output 25 through the circuit board 3. Preferably but not exclusively, in the embodiment, the ground conductor 35 is arranged around an outer periphery of the at least one second fastening hole 34. In that, when the fastening element 5 passes through the first fastening hole 51 and the corresponding second fastening hole 34, and engaged with the engaged element 90 of the housing 9, the connector 1 is fixed to the housing 9, and the ground conductor 35 abuts against the engaged element 90, to simultaneously realize the ground connection of the ground input 19 and the ground output 25 through the ground conductor 35 to the housing 9. In other words, it allows to arrange the ground conductor 35 in conjunction with the main body 2 and the second fastening hole 34 of the circuit board 3 to simultaneously realize the ground connection when the connector 1 is fixed to the housing 9, and the assembling process is further optimized. Certainly, the present disclosure is not limited thereto.

In the embodiment, the connector 1 is assembled with a communication power module 8 on the housing 9 for transmitting the high-current power and signal transmission of the communication power module 8. Preferably but not exclusively, the connector 1 further includes at least one guide groove 52, which is regarded as a guiding structure, recessed on the input side S1, disposed adjacent to at least one lateral end of the input side S1, and configured to guide a docking pin 84 regarded as a docking structure of an external module for insertion from the input side S1 toward the output side S2 along the first direction (i.e., the X axial direction). Consequently, the connector 1 is connected to the external module, and the guide grooves 52 with the asymmetric design provide a fool-proof effect. To be more specific, in the embodiment, two semicircular guide grooves 52 are disposed adjacent to the left and right ends of the input side S1, corresponding to the two left and right docking pins 84 of the communication power module 8, respectively. Certainly, in other embodiments, the positions, the shapes and the numbers of the guide grooves 52 and the docking pins 84 are adjustable according to the practical requirements, and the present disclosure is not limited thereto. The signal inputs 40, the power inputs 10 and the ground input 19 are arranged along the horizontal direction (i.e., the Y axial direction) and located between the two guide grooves 52. Since the signal inputs 40, the power inputs 10 and the ground input 19 are arranged along the horizontal direction (i.e., the Y axial direction) on the input side S1, when the guide grooves 52 disposed on the input side S1 guide the docking pins 84 of the communication power module 8 to insert along the first direction (i.e., the X axial direction) from the input side S1 to the output side S2, it allows to dock the signal connection port 82, the power connection port 81 and the ground port 83 of the communication power module 8 with the signal inputs 40, the power inputs 10 and the ground input 19. In that, the docking of the connector 1 and the communication power module 8 is completed easily, to achieve the power transmission, the signal transmission and the grounding effect, and optimize the assembling process. In the embodiment, the connector 1 is assembled with the communication power module 8, and then the connector 1 is fixed to the housing 9 through the fastening element 5. In another embodiment, the connector 1 is fixed to the housing 9, and then the connector 1 and the communication power module 8 are assembled together. The present disclosure is not limited thereto and not redundantly described hereafter.

Notably, in the above embodiment, many technical features can be combined and adjusted to form a power transmission path from the front input side S1 to the rear output side S2 of the main body 2, and a signal transmission from the front input side S1 through the bottom side S4 of the main body 2 through the bottom surface S4. In other embodiments, the numbers, the sizes, the positions and the corresponding relationships of the power inputs 10, the power outputs 20, the signal inputs 40, the signal outputs 41, the ground input 10 and the ground output 25 are adjustable according to the practical requirements, so as to realize a hybrid power connector 1 suitable for connecting to the communication power module 8. Certainly, the arrangements of the first fastening holes 51, the second fastening holes 34, the ground conductor 35 and the guide grooves 52 are not limited to the illustrated embodiment, and not redundantly described hereafter.

In summary, the present disclosure provides a hybrid power connector suitable for connecting to a communication power module. The connector combines the high-current power supply and signal transmission to reduce the material costs, optimize the assembling process, and improve the space utilization. The power inputs and the power outputs are disposed on the opposite input side and output side of the main body, respectively. Each power output includes for example a copper sheet with a screw-fixing hole, and the wire and the copper bar are fixed to the power output, so as to reduce the cost of materials and optimize the assembling procedures. When the signal inputs and the power inputs are introduced from the front input side, the power inputs are electrically connected to the rear power outputs and led out through the output side, and the signal inputs are electrically connected to the signal outputs on the bottom of the main body and then led out through the inner trace of the circuit board below, so as to increase the space utilization. The signal outputs include a plurality of signal output pins, which are fixed to the circuit board through the soldering process, so that the signal can be led out through the trace of the circuit board to the terminal on the circuit board, such as the signal connection socket on the extension portion, to optimize the assembling process. On the other hand, a plurality of power output pins, disposed on the bottom of the main body and electrically connect to the ground input on the input side, are fixed to the circuit board through the soldering process. In that, the grounding is guided to a specific area through the trace of the circuit board, and the circuit board is overlapped with the other metal parts to achieve the purpose of grounding. It allows to arrange a ground conductor in conjunction with the fastening holes of the main body and the circuit board to simultaneously realize the ground connection when the connector is fixed to the housing, and the assembling process is further optimized. Since the power inputs, the signal inputs and the ground connection terminal are all arranged on the input side, guide grooves can be set on the input side to guide the docking pin of the communication power module for insertion along the direction from the input side to the output side, so as to complete the docking of the communication power module and the connector easily, and optimize the assembling process.

## Claims

1. A connector (1), comprising:
a main body (2) comprising an input side (S1), an output side (S2), a plurality of power inputs (10), a plurality of signal inputs (40), a plurality of power outputs (20) and a plurality of signal outputs (41), wherein the input side (S1) is opposite to the output side (S2) in a first direction (X), the plurality of power inputs (10) and the plurality of signal inputs (40) are arranged along a second direction (Y) on the input side (S1), the first direction is perpendicular to the second direction, the plurality of power outputs (20) are arranged along the second direction (Y) on the output side (S2), the plurality of power outputs (20) are electrically connected to the plurality of power inputs (10), the plurality of signal outputs (41) are disposed on a bottom wall (S4) of the main body (2) and electrically connected to the plurality of signal inputs (40), and the bottom wall (S4) is connected between the input side (S1) and the output side (S2);
**characterized by** a circuit board (3) comprising an upper surface (31) and at least one extension portion (33), wherein the bottom wall (S4) of the main body (2) is attached to said upper surface (31), the at least one extension portion (33) extended from a side of the circuit board (3) along the first direction (X) and disposed adjacent to an end of the output side (S2); and
at least one signal connection socket (4) disposed on the upper surface (31) and electrically connected to the plurality of signal outputs (41) through the circuit board (3), and the at least one signal connection socket (4) is disposed on the at least one extension portion (33), wherein the plurality of signal outputs (41) include a plurality of signal output pins (410) passing through the bottom wall (S4) of the main body (2) and connected to the upper surface (31) of the circuit board (3) so as to electrically connect to the circuit board (3).

2. The connector (1) according to claim 1, wherein the circuit board (3) comprises two extension portions (33) and two signal connection sockets (4), the two extension portions (33) are extended from two opposite ends on the side of the circuit board (3) along the first direction, respectively, and the two signal connection sockets (4) are disposed on the two extension portions (33), respectively.

3. The connector (1) according to claim 1, wherein the at least one signal connection socket (4) is misaligned to the plurality of power outputs (20) in the first direction.

4. The connector (1) according to claim 1, wherein the plurality of power inputs (10) include a plurality of first fixing-terminal apertures (11, 12, 13, 14, 15, 16, 17, 18), the plurality of signal inputs (40) include a plurality of second fixing-terminal apertures (400) arranged adjacent to one side of the plurality of first fixing-terminal apertures (11, 12, 13, 14, 15, 16, 17, 18).

5. The connector (1) according to claim 1, wherein the plurality of power outputs (20) are formed by a plurality of copper sheets (21, 22, 23, 24) arranged along the second direction, and spaced apart from each other.

6. The connector (1) according to claim 1, wherein the plurality of power outputs (20) are formed by a plurality of copper sheets (21, 22, 23, 24) and comprise a plurality of screw-fixing holes (200) respectively configured to fix a wire or a copper bar to a corresponding one of the plurality of power outputs (20) for an electrical connection.

7. The connector (1) according to claim 1, wherein the main body (2) further comprises a ground input (19) and a ground output (25) electrically connected to each other, the ground input (19) is disposed on the input side (S1), and the ground output (25) is disposed on the bottom wall (S4).

8. The connector (1) according to claim 7, wherein the ground output (25) comprises a ground output pin (250) passing through the bottom wall (S4)of the main body (2) and the circuit board (3) so as to be fastened to a housing (9).

9. The connector (1) according to claim 8, wherein the main body (2) comprises at least one first fastening hole (51), the circuit board (3) comprises at least one second fastening hole (34) spatially corresponding to the at least one first fastening hole (51), wherein the at least one first fastening hole (51) and the at least one second fastening hole (34) are configured to fix the connector (1) to the housing (9) along a third direction (Z) perpendicular to both the first direction (X) and the second direction (Y).

10. The connector (1) according to claim 9, wherein the circuit board (3) further comprises a ground conductor (35) disposed on a lower surface (32) of the circuit board (3) and electrically connected to the ground output (25) through the circuit board (3), and the lower surface (32) is opposite to the upper surface (31).

11. The connector (1) according to claim 10, wherein the ground conductor (35) is arranged around an outer periphery of the at least one second fastening hole (34).

12. The connector (1) according to claim 1, further comprising at least one guiding structure (52) recessed on the input side (S1) and configured to guide a docking structure (84) of an external module for insertion from the input side (S1) along the first direction, so that the connector (1) is connected to the external module.

## Patentansprüche

1. Verbinder (1), umfassend:
einen Hauptkörper (2) mit einer Eingangsseite (S1), einer Ausgangsseite (S2), einer Mehrzahl von Stromeingängen (10), einer Mehrzahl von Signaleingängen (40), einer Mehrzahl von Stromausgängen (20) und einer Mehrzahl von Signalausgängen (41), wobei die Eingangsseite (S1) in einer ersten Richtung (X) der Ausgangsseite (S2) gegenüberliegt, die Mehrzahl von Stromeingängen (10) und die Mehrzahl von Signaleingängen (40) entlang einer zweiten Richtung (Y) an der Eingangsseite (S1) angeordnet sind, die erste Richtung senkrecht zur zweiten Richtung verläuft, die Mehrzahl von Stromausgängen (20) entlang der zweiten Richtung (Y) an der Ausgangsseite (S2) angeordnet ist, die Mehrzahl von Stromausgängen (20) mit der Mehrzahl von Stromeingängen (10) elektrisch verbunden ist, die Mehrzahl von Signalausgängen (41) an einer unteren Wand (S4) des Hauptkörpers (2) angeordnet und mit der Mehrzahl von Signaleingängen (40) elektrisch verbunden ist, und die untere Wand (S4) zwischen der Eingangsseite (S1) und der Ausgangsseite (S2) verbunden ist;
**gekennzeichnet durch** eine Leiterplatte (3) mit einer oberen Fläche (31) und mindestens einem verlängerten Bereich (33), wobei die untere Wand (S4) des Hauptkörpers (2) an der oberen Fläche (31) befestigt ist, sich der mindestens eine verlängerte Bereich (33) von einer Seite der Leiterplatte (3) entlang der ersten Richtung (X) erstreckt und benachbart zu einem Ende der Ausgangsseite (S2) angeordnet ist; und
mindestens einen Signalverbindungsanschluss (4), der an der oberen Fläche (31) vorgesehen und durch die Leiterplatte (3) mit der Mehrzahl von Signalausgängen (41) elektrisch verbunden ist, wobei der mindestens eine Signalverbindungsanschluss (4) an dem mindestens einen verlängerten Bereich (33) vorgesehen ist, wobei die Mehrzahl von Signalausgängen (41) eine Mehrzahl von Signalausgangsstiften (410) umfasst, die sich durch die untere Wand (S4) des Hauptkörpers (2) erstrecken und mit der oberen Fläche (31) der Leiterplatte (3) verbunden sind, um eine elektrische Verbindung mit der Leiterplatte (3) herzustellen.

2. Verbinder (1) nach Anspruch 1, wobei die Leiterplatte (3) zwei verlängerte Bereiche (33) und zwei Signalverbindungsanschlüsse (4) umfasst, wobei sich die beiden verlängerten Bereiche (33) jeweils von zwei gegenüberliegenden Enden an der Seite der Leiterplatte (3) entlang der ersten Richtung erstrecken, und die beiden Signalverbindungsanschlüsse (4) jeweils an den beiden verlängerten Bereichen (33) angeordnet sind.

3. Verbinder (1) nach Anspruch 1, wobei der mindestens eine Signalverbindungsanschluss (4) in der ersten Richtung bezüglich den Mehrzahl von Stromausgängen (20) versetzt ist.

4. Verbinder (1) nach Anspruch 1, wobei die Mehrzahl von Stromeingängen (10) eine Mehrzahl von ersten Klemmanschlussöffnungen (11, 12, 13, 14, 15, 16, 17, 18) umfasst, die Mehrzahl von Signaleingängen (40) eine Mehrzahl von zweite Klemmanschlussöffnungen (400) umfasst, die benachbart zu einer Seite der Mehrzahl von ersten Klemmanschlussöffnungen (11, 12, 13, 14, 15, 16, 17, 18) angeordnet sind.

5. Verbinder (1) nach Anspruch 1, wobei die Mehrzahl von Stromausgängen (20) durch eine Mehrzahl von Kupferblechen (21, 22, 23, 24) gebildet ist, die entlang der zweiten Richtung angeordnet und voneinander beabstandet sind.

6. Verbinder (1) nach Anspruch 1, wobei die Mehrzahl von Stromausgängen (20) durch eine Mehrzahl von Kupferblechen (21, 22, 23, 24) gebildet ist und eine Mehrzahl von Schraubbefestigungslöchern (200) umfasst, die jeweils ausgestaltet sind, um einen Draht oder eine Kupferlitze an einem entsprechenden Ausgang der Mehrzahl von Stromausgängen (20) für eine elektrische Verbindung zu befestigen.

7. Verbinder (1) nach Anspruch 1, wobei der Hauptkörper (2) außerdem einen Masseeingang (19) und einen Masseausgang (25) aufweist, die elektrisch miteinander verbunden sind, wobei der Masseeingang (19) an der Eingangsseite (S1) angeordnet ist und der Masseausgang (25) an der unteren Wand (S4) angeordnet ist.

8. Verbinder (1) nach Anspruch 7, wobei der Masseausgang (25) einen Masseausgangsstift (250) umfasst, der sich durch die untere Wand (S4) des Hauptkörpers (2) und die Leiterplatte (3) erstreckt, um an einem Gehäuse (9) befestigt zu werden.

9. Verbinder (1) nach Anspruch 8, wobei der Hauptkörper (2) mindestens ein erstes Befestigungsloch (51) aufweist, die Leiterplatte (3) mindestens ein zweites Befestigungsloch (34) aufweist, das räumlich dem mindestens einen ersten Befestigungsloch (51) entspricht, wobei das mindestens eine erste Befestigungsloch (51) und das mindestens eine zweite Befestigungsloch (34) ausgestaltet sind, um den Verbinder (1) entlang einer dritten Richtung (Z) an dem Gehäuse (9) befestigen, die senkrecht sowohl zur ersten Richtung (X) als auch zur zweiten Richtung (Y) verläuft.

10. Verbinder (1) nach Anspruch 9, wobei die Leiterplatte (3) außerdem einen Masseleiter (35) aufweist, der an einer unteren Fläche (32) der Leiterplatte (3) angeordnet und über die Leiterplatte (3) mit dem Masseausgang (25) elektrisch verbunden ist, und die untere Fläche (32) der oberen Fläche (31) gegenüberliegt.

11. Verbinder (1) nach Anspruch 10, wobei der Masseleiter (35) um einen äußeren Umfang des mindestens einen zweiten Befestigungslochs (34) herum angeordnet ist.

12. Verbinder (1) nach Anspruch 1, der außerdem mindestens eine Führungsstruktur (52) aufweist, die an der Eingangsseite (S1) vertieft ausgebildet und ausgestaltet ist, um eine Andockstruktur (84) eines externen Moduls zu führen, um von der Eingangsseite (S1) entlang der ersten Richtung eingesetzt zu werden, so dass der Verbinder (1) mit dem externen Modul verbunden werden kann.

## Revendications

1. Connecteur (1), comprenant:
un corps principal (2) comprenant un côté d'entrée (S1), un côté de sortie (S2), une pluralité d'entrées de puissance (10), une pluralité d'entrées de signal (40), une pluralité de sorties de puissance (20) et une pluralité de sorties de signal (41), dans lequel le côté d'entrée (S1) est opposé au côté de sortie (S2) dans une première direction (X), la pluralité d'entrées de puissance (10) et la pluralité d'entrées de signal (40) sont agencées le long d'une deuxième direction (Y) sur le côté d'entrée (S1), la première direction est perpendiculaire à la deuxième direction, la pluralité de sorties de puissance (20) sont agencées le long de la deuxième direction (Y) sur le côté de sortie (S2), la pluralité de sorties de puissance (20) sont connectées électriquement à la pluralité d'entrées de puissance (10), la pluralité de sorties de signal (41) sont disposées sur une paroi inférieure (S4) du corps principal (2) et connectées électriquement à la pluralité d'entrées de signal (40), et la paroi inférieure (S4) est connectée entre le côté d'entrée (S1) et le côté de sortie (S2);
**caractérisé par** une carte de circuit imprimé (3) comprenant une surface supérieure (31) et au moins une partie d'extension (33), dans lequel la paroi inférieure (S4) du corps principal (2) est fixée à ladite surface supérieure (31), l'au moins une partie d'extension (33) s'étendant d'un côté de la carte de circuit imprimé (3) le long de la première direction (X) et étant disposée adjacente à une extrémité du côté de sortie (S2); et
au moins une prise de connexion de signal (4) disposée sur la surface supérieure (31) et connectée électriquement à la pluralité de sorties de signal (41) à travers la carte de circuit imprimé (3), et l'au moins une prise de connexion de signal (4) est disposée sur l'au moins une partie d'extension (33), dans lequel la pluralité de sorties de signal (41) incluent une pluralité de broches de sortie de signal (410) passant à travers la paroi inférieure (S4) du corps principal (2) et connectées à la surface supérieure (31) de la carte de circuit imprimé (3) afin de se connecter électriquement à la carte de circuit imprimé (3).

2. Connecteur (1) selon la revendication 1, dans lequel la carte de circuit imprimé (3) comprend deux parties d'extension (33) et deux prises de connexion de signal (4), les deux parties d'extension (33) s'étendant respectivement à partir de deux extrémités opposées sur le côté de la carte de circuit imprimé (3) dans la première direction, et les deux prises de connexion de signal (4) étant respectivement disposées sur les deux parties d'extension (33).

3. Connecteur (1) selon la revendication 1, dans lequel l'au moins une prise de connexion de signal (4) est désalignée par rapport à la pluralité de sorties de puissance (20) dans la première direction.

4. Connecteur (1) selon la revendication 1, dans lequel la pluralité d'entrées d'alimentation (10) incluent une pluralité de premières ouvertures de borne de fixation (11, 12, 13, 14, 15, 16, 17, 18), la pluralité d'entrées de signal (40) incluent une pluralité de secondes ouvertures de borne de fixation (400) agencées adjacentes à un côté de la pluralité de premières ouvertures de borne de fixation (11, 12, 13, 14, 15, 16, 17, 18).

5. Connecteur (1) selon la revendication 1, dans lequel la pluralité de sorties de puissance (20) sont formées par une pluralité de feuilles de cuivre (21, 22, 23, 24) agencées le long de la deuxième direction, et espacées les unes des autres.

6. Connecteur (1) selon la revendication 1, dans lequel la pluralité de sorties de puissance (20) sont formées par une pluralité de feuilles de cuivre (21, 22, 23, 24) et comprennent une pluralité de trous de fixation par vis (200) respectivement configurés pour fixer un fil ou une barre de cuivre à une correspondante de la pluralité de sorties de puissance (20) pour une connexion électrique.

7. Connecteur (1) selon la revendication 1, dans lequel le corps principal (2) comprend en outre une entrée de masse (19) et une sortie de masse (25) connectées électriquement l'une à l'autre, l'entrée de masse (19) est disposée du côté d'entrée (S1), et la sortie de masse (25) est disposée sur la paroi inférieure (S4).

8. Connecteur (1) selon la revendication 7, dans lequel la sortie de masse (25) comprend une broche de sortie de masse (250) traversant la paroi inférieure (S4) du corps principal (2) et la carte de circuit imprimé (3) de manière à être fixée à un boîtier (9).

9. Connecteur (1) selon la revendication 8, dans lequel le corps principal (2) comprend au moins un premier trou de fixation (51), la carte de circuit imprimé (3) comprend au moins un second trou de fixation (34) correspondant spatialement à l'au moins un premier trou de fixation (51), dans lequel l'au moins un premier trou de fixation (51) et l'au moins un second trou de fixation (34) sont configurés pour fixer le connecteur (1) au boîtier (9) le long d'une troisième direction (Z) perpendiculaire à la première direction (X) et la deuxième direction (Y).

10. Connecteur (1) selon la revendication 9, dans lequel la carte de circuit imprimé (3) comprend en outre un conducteur de masse (35) disposé sur une surface inférieure (32) de la carte de circuit imprimé (3) et connecté électriquement à la sortie de masse (25) à travers la carte de circuit imprimé (3), et la surface inférieure (32) est opposée à la surface supérieure (31).

11. Connecteur (1) selon la revendication 10, dans lequel le conducteur de masse (35) est agencé autour d'une périphérie externe de l'au moins un second trou de fixation (34).

12. Connecteur (1) selon la revendication 1, comprenant en outre au moins une structure de guidage (52) évidée sur le côté d'entrée (S1) et configurée pour guider une structure d'arrimage (84) d'un module externe pour insertion depuis le côté d'entrée (S1) le long de la première direction, de sorte que le connecteur (1) soit connecté au module externe.
